# EUROPÄISCHE PATENTSCHRIFT

(11) **EP 1 776 717 B1**
(45) Veröffentlichungstag und Bekanntmachung des Hinweises auf die Patenterteilung: **30.01.2008**
(21) Anmeldenummer: 05769853.2
(22) Anmeldetag: 04.08.2005
(51) Int. Cl.: H01L 21/683, H05K 13/04

(54) **GREIFEREINHEIT, BESTÜCKKOPF UND VERFAHREN ZUM BESTÜCKEN VON SUBSTRATEN MIT ELEKTRISCHEN BAUELEMENTEN**
GRIPPER UNIT, MOUNTING HEAD, AND METHOD FOR FITTING SUBSTRATES WITH ELECTRICAL COMPONENTS
UNITE DE PREHENSION, TETE DE MONTAGE ET PROCEDE POUR APPAREILLER DES SUBSTRATS AVEC DES COMPOSANTS ELECTRONIQUES

(30) Priorität: 10.08.2004 DE 102004038839
(43) Veröffentlichungstag der Anmeldung: 25.04.2007
(73) Patentinhaber: SIEMENS AKTIENGESELLSCHAFT, 80333 München (DE)
(72) Erfinder: BURGER, Stefan, 81379 München (DE)
(86) Internationale Anmeldenummer: PCT/EP2005/053832
(87) Internationale Veröffentlichungsnummer: WO 2006/018387

(56) Entgegenhaltungen:
- EP-A- 0 906 010
- EP-B- 0 768 020
- WO-A-01/95045
- DE-A1- 10 127 735
- DE-B3- 10 255 472

## Beschreibung

Die Erfindung betrifft eine Greifereinheit, einen Bestückkopf und ein Verfahren zum Bestücken von Substraten mit elektrischen Bauelementen

Aus der Offenlegungsschrift EP-0768020 ist eine Vorrichtung zur Handhabung von elektrischen Bauelementen bekannt, mit einer Saugpipette, einer saugseitig an die Saugpipette angeschlossenen Strahlvakuumpumpe zur Erzeugung von Unterdruck beim Aufnehmen und Halten der Bauelemente, und einem Druckbehälter, aus welchem über ein Ventil beim Abgeben der Bauelemente Druckluft in den Unterdruckbereich zwischen der Strahlvakuumpumpe und Saugpipette eingeleitet wird.

Bei der oben genannten Vorrichtung ist die Strahlvakuumpumpe ständig in Betrieb. Zum Abgeben der Bauelemente wird der von der Strahlvakuumpumpe an der Saugpipette erzeugte Unterdruck durch Zuschalten eines Druckbehälters über ein Ventil einfach überblasen. Durch den ständigen Betrieb der Strahlvakuumpumpe ergibt sich ein hoher Druckluftverbrauch, was hohe Betriebskosten der Vorrichtung verursacht.

Der nächstliegende Stand der Technik schließt aus Dokument EP-A2-0 906 010 ein.

Es ist deshalb die Aufgabe der vorliegenden Erfindung, eine Greifereinheit zum Bestücken von Substraten mit elektrischen Bauelementen, einen Bestückkopf für einen Bestückautomaten und ein Verfahren zum Bestücken von Substraten mit elektrischen Bauelementen mit reduziertem Druckluftverbrauch zu liefern.

Diese Aufgabe wird durch die Greifereinheit gemäß dem unabhängigen Anspruch 1, dem Bestückkopf gemäß dem unabhängigen Anspruch 6 und dem Verfahren gemäß dem unabhängigen Anspruch 9 gelöst.

Die Greifereinheit gemäß Anspruch 1 umfasst ein steuerbares Ventil, welches zwischen einem Druckluftanschluss einer Strahlvakuumpumpe und einer Druckluftversorgung vorgesehen ist und einen Sammelbehälter, der mit einem Abluftanschluss der Strahlvakuumpumpe pneumatisch gekoppelt ist. Das steuerbare Ventil kann so angesteuert werden, dass es zum Aufnehmen und Transport von Teilen, z.B. elektrischen Bauelementen, auf eine erste Position eingestellt wird, in der die Druckluftversorgung mit dem Druckluftanschluss der Strahlvakuumpumpe pneumatisch gekoppelt ist. In dieser Position strömt Druckluft über die Strahlvakuumpumpe, so dass an der Ansaugöffnung eines am Vakuumanschluss einer Strahlvakuumpumpe angeschlossenen Greifers Unterdruck anliegt. Die Abluft aus der Strahlvakuumpumpe strömt dabei in den Sammelbehälter, wo sie gespeichert wird. Zum Abgeben der Teile und in den Zeiträumen, in denen kein Teil von dem Greifer angesaugt oder transportiert werden soll, wird das steuerbare Ventil auf eine zweite Position geschaltet, in der die Strahlvakuumpumpe von der Druckluftversorgung getrennt und dadurch deaktiviert ist. Dabei strömt die im Sammelbehälter unter Druck gespeicherte Abluft der Strahlvakuumpumpe zurück über die Strahlvakuumpumpe zu der Ansaugöffnung des Greifers und das Teil wird abgeblasen.

Bei der oben beschriebenen Greifereinheit kann das steuerbare Ventil so geschaltet werden, dass die Druckluftversorgung (Treibmittelzufuhr) der Strahlvakuumpumpe nur bei Bedarf, z. B. beim Abholen und Transport der Bauelemente, zugeschaltet wird. In den Zeiträumen, in denen am Greifer kein Teil anliegt, kann die Druckluftversorgung abgeschaltet werden. Weiterhin wird die im Sammelbehälter unter Druck gespeicherte Abluft der Strahlvakuumpumpe insofern wieder verwertet, dass sie bei abgeschalteter Druckluftversorgung über die Strahlvakuumpumpe zur Ansaugöffnung des Greifers strömt und dort als Abblasdruckluft der Teile dient. Somit wird auch zum Abblasen der Teile vom Greifer keine zusätzliche Druckluft benötigt.

Mit der erfindungsgemäßen Greifereinheit können somit die Kosten für die Druckluftversorgung erheblich reduziert werden.

Bei einer Ausgestaltung der Greifereinheit nach Anspruch 2 sind das steuerbare Ventil und der Druckluftanschluss der Strahlvakuumpumpe über eine Druckluftleitung miteinander verbunden. Dadurch können das steuerbare Ventil und die Strahlvakuumpumpe örtlich getrennt voneinander vorgesehen werden, was eine höhere Flexibilität bei der Montage mit sich bringt.

Bei der Ausgestaltung der Greifereinheit nach Anspruch 3 verfügt das steuerbare Ventil über eine Entlüftungsöffnung, über die das Ventil selbst und die das Ventil und den Druckluftanschluss der Strahlvakuumpumpe verbindende Druckluftleitung entlüftet werden, wenn sich das steuerbare Ventil in der zweiten Position befindet. Dadurch fällt der Druck im Ventil und in der Druckluftleitung beim Umschalten auf die zweite Position des Ventils sehr schnell ab, so dass die Umschaltzeiten zwischen Vakuum und Blasdruck an der Ansaugöffnung des Greifers deutlich verkürzt werden.

In einer weiteren Ausgestaltung der Greifereinheit nach Anspruch 4 entlüften das Ventil und die Druckluftleitung über die Ansaugöffnung des Greifers. Dadurch wird beim Umschalten des Ventils auf die zweite Position ein kurzer Druckimpuls in den Vakuumanschluss der Strahlvakuumpumpe eingeleitet, was die Umschaltzeit zwischen Vakuum und Blasdruck an der Ansaugöffnung des Greifers weiter reduziert.

Gemäß einer Ausgestaltung der Greifereinheit nach Anspruch 5 ist es auch möglich, das steuerbare Ventil direkt an der Strahlvakuumpumpe vorzusehen. Dadurch, dass in diesem Fall zwischen dem steuerbaren Ventil und der Strahlvakuumpumpe kein zusätzliches Volumen, beispielsweise eine Druckluftleitung vorhanden ist, können auch ohne Entlüftung des Ventils schnelle Umschaltzeiten zwischen Vakuum und Blasdruck an der Ansaugöffnung des Greifers erzielt werden.

Ein Bestückkopf für einen Bestückautomaten gemäß Anspruch 6 umfasst mindestens zwei der oben beschriebenen Greifereinheiten, jedoch mit der Ausnahme, dass nicht jede Greifereinheit einen eigenen Sammelbehälter für die Abluft der Strahlvakuumpumpe umfasst, sondern jeweils ein gemeinsamer Sammelbehälter für die Abluft von mindestens zwei Strahlvakuumpumpen vorgesehen ist. Durch den gemeinsamen Sammelbehälter wird der Aufbau des Bestückkopfs vereinfacht. Des Weiteren gelten für diesen Bestückkopf die oben für die Greifereinheiten beschriebenen Vorteile.

Gemäß einer Ausgestaltung nach Anspruch 7 kann an dem gemeinsamen Sammelbehälter ein Druckregelventil vorgesehen sein, mit welchem sich der Druck im Sammelbehälter einstellen lässt.

Bei der Ausgestaltung des Bestückkopfs nach Anspruch 8 werden die einzelnen Greifereinheiten von einem mit einer externen Druckluftversorgung verbundenen Druckluftspeicher am Bestückkopf mit Druckluft versorgt. Dieser Druckluftspeicher bringt den Vorteil, dass zu jedem Zeitpunkt für alle Greifereinheiten ausreichend Druckluft zur Verfügung steht. Außerdem werden durch diesen zwischen der externen Druckluftversorgung und den Greifereinheiten zwischengeschalteten Druckluftspeicher die Schaltzeiten verkürzt.

Gemäß einem Verfahren zum Bestücken von Substraten mit elektrischen Bauelementen nach Anspruch 9, sind die Strahlvakuumpumpen bestenfalls nur zum Aufnehmen und Transportieren der elektrischen Bauelemente aktiviert. Die dabei anfallende Abluft der Strahlvakuumpumpen wird in einem gemeinsamen Sammelbehälter gesammelt. Während des eigentlichen Bestückvorgangs werden die steuerbaren Ventile individuell auf die zweite Position gestellt, wodurch die elektrischen Bauelemente durch die im Sammelbehälter unter Druck gespeicherte Abluft von den Greifern abgeblasen werden. Nachdem sämtliche Bauelemente abgeblasen sind, werden die steuerbaren Ventile noch vor dem Bewegen des Bestückkopfes zu der Abholebene, an der die elektrischen Bauelemente bereitgestellt werden, auf die zweite Position geschaltet, d.h. die Strahlvakuumpumpen werden deaktiviert. Dieses Verfahren bringt den Vorteil, dass zumindest während des Verfahrvorganges des Bestückkopfes zur Abholebene keine Druckluft verbraucht wird. Die Druckluftkosten können dadurch minimiert werden.

In der Ausgestaltung nach Anspruch 10 wird vor dem Aufnehmen der Bauelemente der Druck im gemeinsamen Sammelbehälter durch ein am Sammelbehälter vorgesehenes Druckregelventil möglichst weit, idealerweise bis auf Umgebungsdruck abgesenkt. Dadurch wird verhindert, dass vor dem Aufnehmen der Bauelemente Blasdruck an den Ansaugöffnung des Greifers anliegt und Bauelemente weggeblasen werden.

Das Verfahren kann gemäß Anspruch 11 auch dahin ausgestaltet werden, dass vor dem Bestücken des Substrats der Druck im gemeinsamen Sammelbehälter durch das Druckregelventil auf einen Abluftblasdruck erhöht wird, der oberhalb des Umgebungsdrucks liegt. Dadurch wird gewährleistet, dass beim Bestücken schon ein ausreichend hoher Druck im gemeinsamen Sammelbehälter herrscht. Das Abblasen der elektrischen Bauelemente kann dadurch beschleunigt werden.

Gemäß Anspruch 12 kann das Verfahren auch dahingehend ausgestaltet werden, dass das Druckregelventil den Abblasdruck entsprechend der Größe oder dem Gewicht der elektrischen Bauelemente einstellt. Dies erhöht die Sicherheit des Bestückvorganges.

Gemäß einer weiteren Ausgestaltung des Verfahrens nach Anspruch 13 wird vor dem Abblasen des letzten elektrischen Bauelements die Strahlvakuumpumpe einer anderen Greifereinheit zumindest so lange aktiviert, bis das letzte elektrische Bauelement abgeblasen ist. Dadurch wird verhindert, dass es vor oder während des Abblasvorganges des letzten Bauelements zu einem Druckabfall im gemeinsamen Sammelbehälter kommt, so dass auch das letzte elektrische Bauelement sicher abgeblasen werden kann.

Im Folgenden werden vorteilhafte Ausgestaltungen der erfindungsgemäßen Greifereinheit des erfindungsgemäßen Bestückkopfes und das erfindungsgemäße Verfahren anhand der beigefügten Zeichnungen näher erläutert. Dabei stellen
Figur 1 eine Ausgestaltung der Greifereinheit dar, wobei das schaltbare Ventil auf eine erste Position eingestellt ist;
Figur 2 die Ausgestaltung der Greifereinheit aus Fig. 1 dar, wobei das steuerbare Ventil auf eine zweite Position gestellt ist;
Figur 3 eine weitere Ausgestaltung der Greifereinheit dar, wobei das steuerbare Ventil auf eine erste Position eingestellt ist;
Figur 4 die vorteilhafte Ausgestaltung der Greifereinheit aus Figur 3 dar, wobei das steuerbare Ventil auf eine zweite Position eingestellt ist;
Figur 5 eine weitere vorteilhafte Ausgestaltung der erfindungsgemäßen Greifereinheit dar, wobei das schaltbare Ventil in einer ersten Position geschaltet ist;
Figur 6 die Ausgestaltung der Greifereinheit aus Figur 5 dar, wobei das steuerbare Ventil in einer zweiten Position eingestellt ist;
Figur 7 den schematischen Aufbau eines Bestückkopfes mit mehreren Greifereinheiten, wie sie in Figur 5 und 6 dargestellt sind, dar.

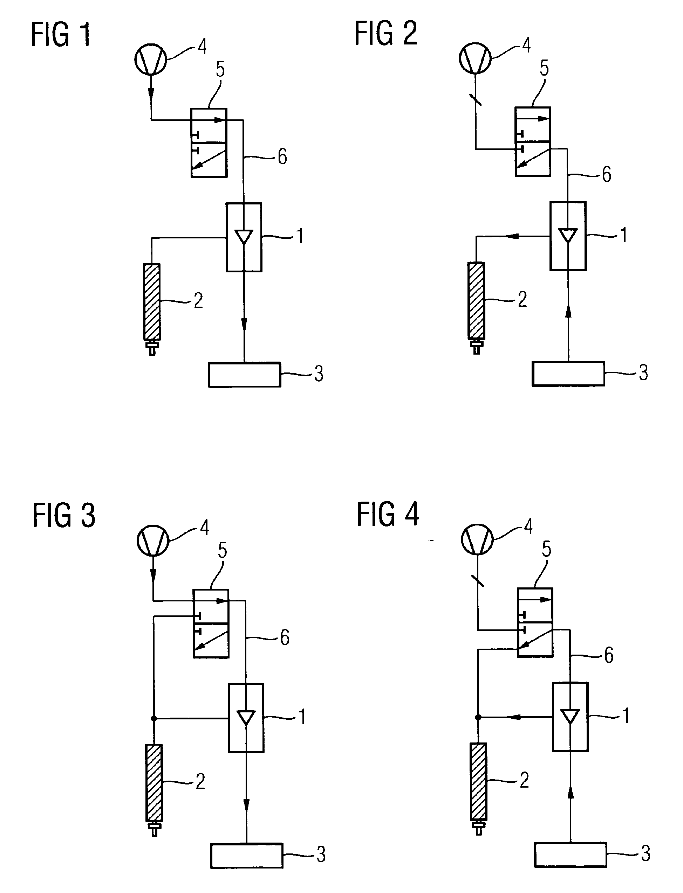

In den Figuren 1 bis 7 ist die Strömungsrichtung der Druckluft durch Pfeile dargestellt.

Aus dem in den Figs. 1 und 2 dargestellten Ausführungsbeispiel wird der grundsätzliche Aufbau einer erfindungsgemäßen Greifereinheit deutlich. Die Greifereinheit besteht aus einer Strahlvakuumpumpe (1), beispielsweise einer Venturidüse, welche einen Druckluftanschluss, einen Vakuumanschluss und einen Abluftanschluss aufweist. Des Weiteren gehören zur Greifereinheit ein Greifer (2) (beispielsweise eine Saugpipette), der an seiner Unterseite eine Ansaugöffnung aufweist, mit der Teile, z.B. elektrische Bauelemente, angesaugt werden können. Die Ansaugöffnung ist mit dem Vakuumanschluss der Strahlvakuumpumpe (1) pneumatisch verbunden, so dass bei aktivierter Strahlvakuumpumpe (1) Unterdruck an der Ansaugöffnung anliegt. In diesem Zustand können Teile von dem Greifer (2) angesaugt werden. Die Greifereinheit umfasst des Weiteren einen Sammelbehälter (3), der mit dem Abluftanschluss der Strahlvakuumpumpe (1), zum Beispiel über einen Schlauch, pneumatisch verbunden ist. Zwischen einer Druckluftversorgung (4) und dem Druckanschluss der Strahlvakuumpumpe (1) ist ein steuerbares Ventil (5) vorgesehen ist. Das steuerbare Ventil (5) kann auf zwei verschiedene Positionen eingestellt werden. In einer ersten Position (Fig. 1) verbindet das Ventil (5) die Druckluftversorgung (4) mit der Strahlvakuumpumpe (1). In diesem Zustand strömt Druckluft von der Druckluftversorgung (4) über das steuerbare Ventil (5) durch die Strahlvakuumpumpe (1) in den Sammelbehälter (3), wo sie gespeichert wird. Dadurch, dass die Abluft unter hohem Druck in den Sammelbehälter (3) strömt, herrscht auch im Sammelbehälter (3) ein Druck, der größer ist als der Umgebungsdruck (beispielsweise 150mbar). Wird das steuerbare Ventil (5) auf eine zweite Position (Fig. 2) geschaltet, so wird die Verbindung zwischen der Druckluftversorgung (4) und der Strahlvakuumpumpe (1) getrennt, wobei die Strahlvakuumpumpe (1) deaktiviert wird. Durch den Druckabfall am Druckluftanschluss der Strahlvakuumpumpe (1) strömt die im Sammelbehälter (3) unter Druck gespeicherte Abluft zurück in die Strahlvakuumpumpe (1) und über die Ansaugöffnung des Greifers (2) ins Freie. Dadurch, dass in diesem Zustand an der Ansaugöffnung des Greifers (2) ein Überdruck anliegt, wird das aufgenommene Teil abgeblasen. Speziell das in den Figuren 1 und 2 dargestellte steuerbare Ventil (5) der Greifereinheit verfügt über eine Entlüftungsöffnung. Über diese Entlüftungsöffnung werden das Ventil (5) und ein eventueller Strömungskanal (6) zwischen dem Ventil (5) und der Strahlvakuumpumpe (1) entlüftet, wenn sich das steuerbare Ventil (5) in der zweiten Position befindet (Fig. 2). In dem in den Figuren 1 und 2 dargestellten Ausführungsbeispiel entlüften das Ventil (5) und der Strömungskanal (6) an die freie Umgebung. Die Möglichkeit der Entlüftung des steuerbaren Ventils (5) und des Strömungskanals (6) ist besonders dann vorteilhaft, wenn das Ventil (5) und die Strahlvakuumpumpe (1) getrennt voneinander montiert sind und der Strömungskanal (6) relativ lang ist. Dadurch wird der Überdruck im Ventil (5) und in dem Strömungskanal (6) beim Umschalten des Ventils (5) von der ersten auf die zweite Position schneller abgebaut, was das Rückströmen der Abluft aus dem Sammelbehälter (3) zur Ansaugöffnung des Greifers (2) beschleunigt. Somit werden die Umschaltzeiten zwischen Vakuum und Abblasen weiter verkürzt.

Ein weiteres vorteilhaftes Ausführungsbeispiel der erfindungsgemäßen Greifereinheit wird anhand der Figuren 3 und 4 beschrieben. Die darin dargestellte Greifereinheit weist denselben prinzipiellen Aufbau wie das Ausführungsbeispiel der Figuren 1 und 2 auf. Die Entlüftungsöffnung des steuerbaren Ventils (5) ist jedoch zusätzlich über eine Verbindungsleitung mit der Ansaugöffnung des Greifers (2) pneumatisch verbunden. Wenn das steuerbare Ventil (5) in die zweite Position geschaltet wird (Fig. 4), entlüftet das Ventil (5) und der zwischen dem Ventil (5) und der Strahlvakuumpumpe (1) vorgesehene Strömungskanal (6) über die Ansaugöffnung des Greifers (2). Dadurch entsteht an der Saugseite der Strahlvakuumpumpe (1) ein kurzer Druckimpuls, welcher das Rückströmen der im Sammelbehälter (3) gespeicherten Abluft zur Ansaugöffnung des Greifers (2) beschleunigt. Somit kann die Umschaltzeit zwischen Unterdruck und Abblasdruck an der Ansaugöffnung des Greifers (2) zusätzlich verkürzt werden. Auch dieses Ausführungsbeispiel eignet sich insbesondere für Greifereinheiten, bei denen das steuerbare Ventil (5) und die Strahlvakuumpumpe (1) getrennt angeordnet und über einen längeren Verbindungsschlauch miteinander verbunden sind.

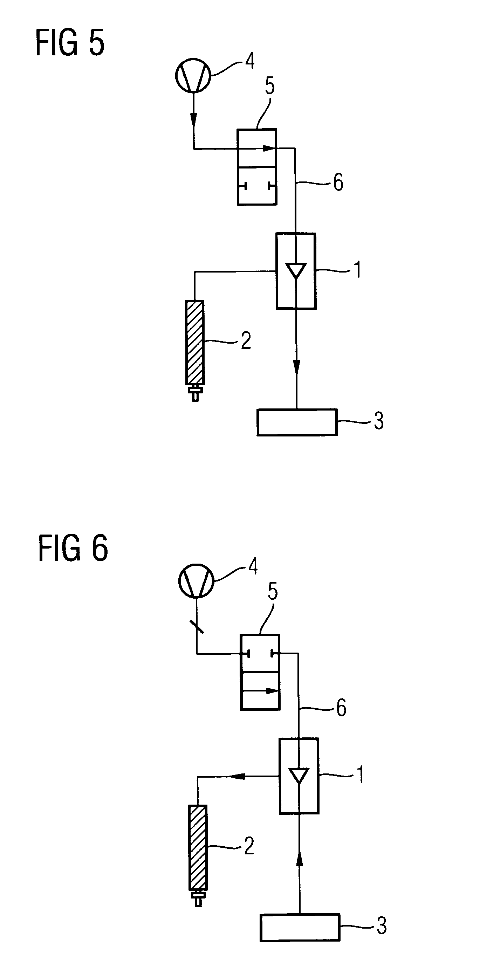

Ein drittes vorteilhaftes Ausführungsbeispiel der erfindungsgemäßen Greifereinheit wird anhand der Figuren 5 und 6 beschrieben. Auch die hier dargestellte Greifereinheit weist denselben prinzipiellen Aufbau wie die Ausführungsformen der Figuren 1 bis 4 auf. Im Unterschied dazu ist das steuerbare Ventil (5) als nicht entlüftbares Ventil (5) ausgestaltet, das heißt, es verfügt über keine Entlüftungsöffnung. Mit einem derartigen als 2/2-Schaltventil bezeichneten Ventil (5) wird die Strahlvakuumpumpe (1) in der ersten Position (Fig. 1) mit der Druckluftversorgung (4) verbunden und in der zweiten Position (Fig. 2) von dieser getrennt. Eine Entlüftung des Ventils (5) findet nicht statt. Derartige Ventile (5) haben jedoch den Vorteil, dass sie einfach im Aufbau und sehr zuverlässig sind. Aufgrund der fehlenden Entlüftung muss das Volumen zwischen dem Ventil (5) und der Strahlvakuumpumpe (1) möglichst klein gehalten werden, um den Auf- und Abbau des Drucks möglichst kurz zu halten. Ein derartiges steuerbares Ventil (5) sollte entweder direkt an der Strahlvakuumpumpe (1) oder mit sehr geringem Abstand zur Strahlvakuumpumpe (1) angebracht werden.

Grundsätzlich kann das steuerbare Ventil (5) als Magnetventil oder Piezoventil, welches sehr kurze Schaltzeiten aufweist, ausgeführt werden. Auch die Verwendung eines Proportionalventils, mit welchem an der Ansaugöffnung des Greifers (2) ein beliebiger Druck zwischen Vakuum und Umgebungsdruck einstellbar wäre, ist denkbar. Dadurch können die Ansaugdrücke an der Ansaugöffnung des Greifers (2) entsprechend den physikalischen Eigenschaften des elektrischen Bauelements, wie z. B. Größe oder Gewicht, geregelt werden.

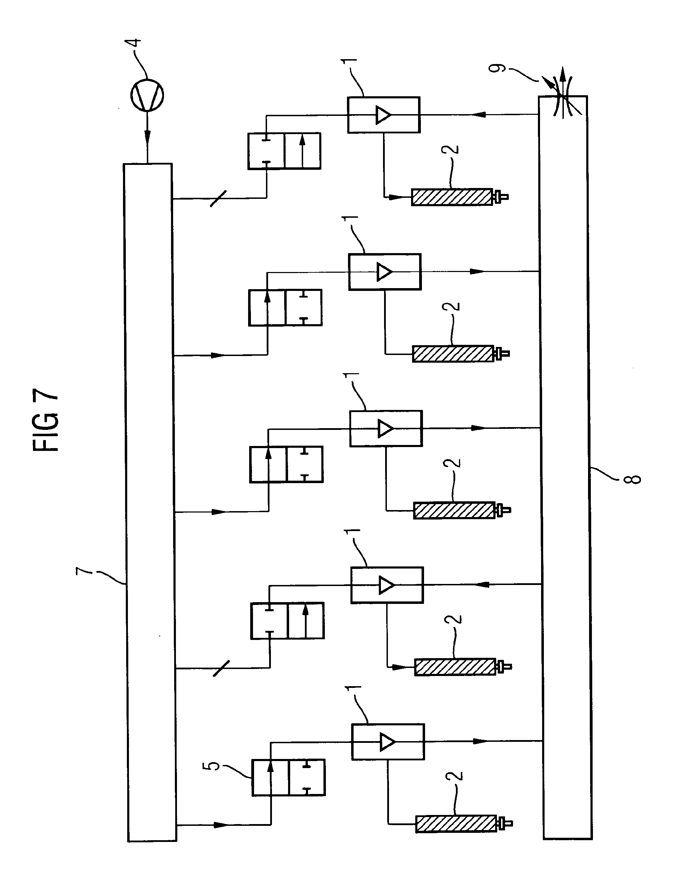

In Figur 7 ist eine Ausführungsform eines erfindungsgemäßen Bestückkopfes dargestellt. Der Bestückkopf verfügt über eine Vielzahl von Greifereinheiten, wie sie in den Figuren 5 und 6 dargestellt. Jedoch können genauso die Greifereinheiten der Figuren 1 bis 4 verwendet werden. Der Bestückkopf verfügt über einen Druckspeicher (7), der mit einer am Bestückkopf oder am Bestückautomaten vorgesehenen Druckluftversorgung (4) pneumatisch gekoppelt ist und von dieser mit Druckluft versorgt wird. Die einzelnen Greifereinheiten werden von diesem Druckspeicher (7) zentral mit Druckluft versorgt. Die Verwendung eines derartigen Druckspeichers (7) bringt zwei wesentliche Vorteile mit sich. Zum Einen wird gewährleistet, dass für den Betrieb der Strahlvakuumpumpen (1) zu jedem Zeitpunkt ausreichend Druckluft mit einheitlichem Druck vorhanden ist, zum Anderen können die Versorgungsleitungen zu den Greifereinheiten deutlich verkürzt werden, wodurch die Schaltzeiten bzw. Totzeiten erheblich reduziert werden.

Anstatt jeder einzelnen Greifereinheit einen individuellen Sammelbehälter (3) zuzuordnen, verfügt der in Figur 7 dargestellte Bestückkopf über einen gemeinsamen Sammelbehälter (8) für alle Greifereinheiten. Dadurch strömt die Abluft aller Strahlvakuumpumpen (1) in diesen einen Sammelbehälter (8). An dem Sammelbehälter (8) ist ein Druckregelventil (9) angebracht, mit welchem der Druck im Sammelbehälter (8) entsprechen den Anforderungen eingestellt werden kann.

Ein erfindungsgemäßes Verfahren zum Bestücken von Substraten mit Bauelementen, wie es beispielsweise für einen in Figur 7 dargestellten Bestückkopf anwendbar ist, wird im Folgenden beispielhaft beschrieben.

In einer Ausgangsposition sind die steuerbaren Ventile (5) der Greifereinheiten auf die zweite Position geschaltet, d.h. die Strahlvakuumpumpen (1) sind deaktiviert. Der verfahrbare Bestückkopf des Bestückautomaten wird zunächst zu einer Abholebene, in der die elektrischen Bauelemente durch entsprechende Zuführeinrichtungen am Bestückautomaten bereitgestellt werden, bewegt. Bei dem Bestückkopf kann es sich um einen so genannten Matrix-Bestückkopf handeln, bei dem die Greifereinheiten in einer Ebene in Form einer Matrix angeordnet sind. Noch während des Verfahrvorgangs kann der Druck im Sammelbehälter (8) durch das Druckregelventil (9) auf Umgebungsdruck abgesenkt werden. Zum Aufnehmen der elektrischen Bauelemente werden die steuerbaren Ventile (5) der entsprechenden Greifereinheiten individuell auf die erste Position geschaltet (Strahlvakuumpumpe (1) aktiviert), so dass die Bauelemente an die Ansaugöffnung der Greifer (2) angesaugt werden. Während der Aufnahme der elektrischen Bauelemente bleibt das Druckregelventil (9) am gemeinsamen Sammelbehälter (8) voll geöffnet, so dass der Gegendruck im gemeinsamen Sammelbehälter (8) minimiert wird. Dadurch kann der Unterdruck an den Ansaugöffnungen der Greifer (2) schneller aufgebaut werden. Nach Beendigung des Aufnahmevorganges wird das Druckregelventil (9) zumindest soweit geschlossen, dass sich im gemeinsamen Sammelbehälter (8) ein Überdruck einstellt. Der Bestückkopf wird nun zu einer Bestückebene des Bestückautomaten verfahren, in welcher das zu bestückende Substrat bereitgestellt wird. Während des Verfahrvorgangs des Bestückkopfes strömt die Abluft der Strahlpumpen all derjenigen Greifereinheiten, die ein elektrisches Bauelement aufgenommen haben, in den gemeinsamen Sammelbehälter (8). Vor dem eigentlichen Bestückvorgang wird das Druckregelventil am gemeinsamen Sammelbehälter (8) so angesteuert, dass sich im gemeinsamen Sammelbehälter (8) ein den physikalischen Eigenschaften (Größe, Gewicht) angepasster Abblasdruck einstellt. Der eigentliche Bestückvorgang läuft dann so ab, dass die steuerbaren Ventile (5) der jeweiligen Greifereinheiten individuell auf die zweite Position geschaltet werden, so dass die an den Ansaugöffnungen der Greifer (2) angesaugten elektrischen Bauelemente an der vorhergesehenen Position auf dem Substrat abgeblasen werden. Die steuerbaren Ventile (5) bleiben dabei zumindest solange in dieser zweiten Position, dass das elektrische Bauelement sicher abgeblasen werden kann. Insbesondere bei kleinen und leichten Bauelementen kann es von Vorteil sein, die steuerbaren Ventile (5) unmittelbar nach dem Abblasen wieder in die erste Position zu schalten, um ein Wegblasen der Bauelemente vom Substrat zu verhindern. Dadurch wird der Bestückvorgang sicherer. Insbesondere bei größeren oder schwereren Bauelementen, welche durch die Blasluft der Greifereinheiten nicht vom Substrat geblasen werden können, können die schaltbaren Ventile (5) auch nach dem Abblasvorgang in der zweiten Position bleiben. Da die Strahlvakuumpumpen (1) in dieser zweiten Position deaktiviert sind, kann zusätzlich Druckluft eingespart werden. Während des Bestückvorgangs wird das Druckregelventil (9) am gemeinsamen Sammelbehälter (8) so angesteuert, dass auch nach Deaktivierung einzelner Strahlvakuumpumpen (1) der benötigte Abblasdruck im Sammelbehälter (8) eingestellt bleibt. Um einen Druckabfall im Sammelbehälter (8) vor dem Abblasen der letzten Bauelemente zu verhindern, können die schaltbaren Ventile (5) der Greifereinheiten, von denen die elektrischen Bauelemente bereits abgeblasen wurden, auf die erste Position eingestellt bleiben oder wieder dorthin umgeschaltet werden. Dadurch wird sichergestellt, dass der Druck im gemeinsamen Sammelbehälter (8) einen erforderlichen Mindestabblasdruck nicht unterschreitet und alle elektrischen Bauelemente sicher abgeblasen werden können. Nach Vollendung des Bestückvorganges werden die steuerbaren Ventile (5) der Greifereinheiten wieder auf die zweite Position eingestellt, das heißt, alle Strahlvakuumpumpen (1) werden deaktiviert. Anschließend wird der Bestückkopf wieder zur Abholebene verfahren und ein neuer Bestückzyklus beginnt.

Durch das oben beschriebene Verfahren wird deutlich, dass die Strahlvakuumpumpen (1) der einzelnen Greifereinheiten im besten Fall immer nur dann aktiviert sind, wenn gerade Bauelemente aufgenommen oder transportiert werden müssen. Dies bedeutet, dass die Strahlvakuumpumpen (1) zumindest teilweise während des Bestückvorganges sowie während des gesamten Bewegungsvorganges von der Bestückebene zur Abholebene deaktiviert sind. Dies bringt eine erhebliche Einsparung an Druckluft und damit eine Erniedrigung der Druckluftkosten mit sich.

Es sei darauf hingewiesen, dass die oben beschriebene Greifereinheit, der Bestückkopf und das entsprechende Verfahren zum Bestücken nicht auf Bestückautomaten limitiert sind, sondern auf jegliche Systeme, bei denen zu transportierende Teile durch Ansaugen mittels Unterdruck aufgenommen und transportiert werden, anwendbar sind.

### Bezugszeichenliste

- 1: Strahlvakuumpumpe
- 2: Greifer
- 3: Sammelbehälter
- 4: Druckluftversorgung
- 5: Steuerbares Ventil
- 6: Strömungskanal
- 7: Druckspeicher
- 8: Gemeinsamer Sammelbehälter
- 9: Druckregelventil

## Patentansprüche

1. Greifereinheit, insbesondere für einen Bestückautomaten zum Bestücken von Substraten mit elektrischen Bauelementen, mit
- einer Strahlvakuumpumpe (1), welche einen Druckluftanschluss, einen Vakuumanschluss und einen Abluftanschluss aufweist,
- einem Greifer (2), der eine Ansaugöffnung insbesondere zur Aufnahme elektrischer Bauelemente aufweist, wobei die Ansaugöffnung mit dem Vakuumanschluss pneumatisch gekoppelt ist, und
- einem Sammelbehälter (3), der mit dem Abluftanschluss pneumatisch gekoppelt ist,
**dadurch gekennzeichnet, daß**
die Greifereinheit mit einem steuerbaren Ventil (5), welches zwischen dem Druckluftanschluss und einer Druckluftversorgung (4) vorgesehen ist, versehen ist, wobei das steuerbare Ventil (5)
in einer ersten Position die Druckluftversorgung (4) mit dem Druckluftanschluss der Strahlvakuumpumpe (1) pneumatisch koppelt, so dass Druckluft über die Strahlvakuumpumpe (1) in den Sammelbehälter (3) strömt und an der Ansaugöffnung des Greifer (2) Vakuum anliegt, und
in einer zweiten Position die Strahlvakuumpumpe (1) von der Druckluftversorgung (4) trennt, sodass im Sammelbehälter (3) gespeicherte Abluft der Strahlvakuumpumpe (1) über die Strahlvakuumpumpe (1) zur Ansaugöffnung des Greifers (2) strömt.

2. Greifereinheit nach Anspruch 1, **dadurch gekennzeichnet, dass** das steuerbare Ventil (5) und der Druckluftanschluss der Strahlvakuumpumpe (1) über einen Strömungskanal (6) pneumatisch gekoppelt sind.

3. Greifereinheit nach Anspruch 2, **dadurch gekennzeichnet, dass** das steuerbare Ventil (5) eine Entlüftungsöffnung aufweist, über die das Ventil (5) und der Strömungskanal (6) entlüften, wenn das steuerbare Ventil (5) in der zweiten Position eingestellt ist.

4. Greifereinheit nach Anspruch 3, **dadurch gekennzeichnet, dass** die Entlüftungsöffnung des Ventils (5) und die Ansaugöffnung des Geifers pneumatisch gekoppelt sind.

5. Greifereinheit nach Anspruch 1, **dadurch gekennzeichnet, dass** das steuerbare Ventil (5) direkt an der Strahlvakuumpumpe (1) vorgesehen ist.

6. Bestückkopf für einen Bestückautomaten, mit mindestens zwei Greifereinheiten nach einem der Ansprüche 1 bis 5, **dadurch gekennzeichnet, dass** die Sammelbehälter (3) von zumindest jeweils zwei Greifereinheiten als ein gemeinsamer Sammelbehälter (8) ausgebildet sind, in den die Abluft der Strahlvakuumpumpen (1) strömt.

7. Bestückkopf nach Anspruch 6, **dadurch gekennzeichnet, dass** an dem gemeinsamen Sammelbehälter (8) ein Druckregelventil (9) vorgesehen ist.

8. Bestückkopf nach einem der Ansprüche 6 oder 7, **dadurch gekennzeichnet, dass** der Bestückkopf einen mit der Druckluftversorgung (4) gekoppelten Druckluftspeicher (7) aufweist, der die Greifereinheiten mit Druckluft versorgt.

9. Verfahren zum Bestücken von Substraten mit elektrischen Bauelementen für einen Bestückautomaten mit einem verfahrbaren Bestückkopf, der mindestens zwei Greifereinheiten aufweist, wobei die Greifereinheiten jeweils
- eine Strahlvakuumpumpe (1), welche einen Druckluftanschluss, einen Vakuumanschluss und einen Abluftanschluss aufweist,
- einen Greifer (2), der eine Ansaugöffnung insbesondere zur Aufnahme elektrischer Bauelemente aufweist, wobei die Ansaugöffnung mit dem Vakuumanschluss pneumatisch gekoppelt ist,
- ein steuerbares Ventil (5), welches zwischen dem Druckluftanschluss und einer Druckluftversorgung (4) vorgesehen ist, aufweisen, und
mindestens ein gemeinsamer Sammelbehälter (8) vorgesehen ist, der mit mindestens zwei Abluftanschlüssen pneumatisch gekoppelt ist, und das steuerbare Ventil (5)
in einer ersten Position die Druckluftversorgung (4) mit dem Druckluftanschluss der Strahlvakuumpumpe (1) pneumatisch koppelt, sodass Druckluft über die Strahlvakuumpumpe (1) in den gemeinsamen Sammelbehälter (8) strömt und an der Ansaugöffnung des Greifer (2) Vakuum anliegt, und
in einer zweiten Position die Strahlvakuumpumpe (1) von der Druckluftversorgung (4) trennt, sodass in dem gemeinsamen Sammelbehälter (8) gespeicherte Abluft der Strahlvakuumpumpe (1) über die Strahlvakuumpumpe (1) zur Ansaugöffnung des Greifers (2) strömt, wobei das Verfahren folgende Schritte umfasst
- Schalten der steuerbaren Ventile (5) auf die zweite Position,
- Bewegen des Bestückkopfs zu einer Abholebene der elektrischen Bauelemente,
- Aufnehmen der elektrischen Bauelemente durch die Greifer (2), indem das steuerbare Ventile (5) des jeweils aufnehmenden Greifers (2) in die erste Position geschaltet wird und das elektrischen Bauelement an die Ansaugöffnung angesaugt wird,
- Bewegen des Bestückkopfs zu einer Bestückebene,
- Bestücken des Substrats mit den elektrischen Bauelementen, indem das steuerbare Ventil (5) des jeweils bestückenden Greifers (2) zumindest solange auf die zweite Position gestellt wird, dass das elektrische Bauelement abgeblasen wird.

10. Verfahren nach Anspruch 9, **dadurch gekennzeichnet, dass** vor dem Aufnehmen der elektrischen Bauelemente der Druck im gemeinsamen Sammelbehälter (8) durch ein am Sammelbehälter (3) vorgesehenes Druckregelventil (9) abgesenkt wird.

11. Verfahren nach Anspruch 10, **dadurch gekennzeichnet, dass** vor dem Bestücken des Substrats der Druck im gemeinsamen Sammelbehälter (8) durch das Druckregelventil (9) auf einen Abblasdruck, der größer ist als der Umgebungsdruck, erhöht wird.

12. Verfahren nach Anspruch 11, **dadurch gekennzeichnet, dass** das Druckregelventil (9) der Größe oder dem Gewicht der elektrischen Bauelemente angepassten Abblasdruck einstellt.

13. Verfahren nach einem der Ansprüche 9 bis 12, **dadurch gekennzeichnet, dass** vor dem Abblasen des letzten elektrischen Bauelements von einer Greifereinheit, das steuerbare Ventil (5) von mindestens einer anderen Greifereinheit zumindest solange auf die erste Position eingestellt wird, bis das letzte elektrischen Bauelement abgeblasen ist.

## Claims

1. Gripper unit, particularly for a pick-and-place machine for mounting electrical components on substrates, comprising
- a vacuum jet pump (1) having a compressed air connection, a vacuum connection and an outlet air connection ,
- a gripper (2) which has a suction port particularly for picking up electrical components, the suction port being pneumatically coupled to the vacuum connection, and
- a receiver tank (3) which is pneumatically coupled to the outlet air connection,
**characterised in that**
the gripper unit is provided with a controllable valve (5) which is provided between the compressed air connection and a compressed air supply (4),
wherein the controllable valve (5)
in a first position pneumatically couples the compressed air supply (4) to the compressed air connection of the vacuum jet pump (1) so that compressed air flows via the vacuum jet pump (1) into the receiver tank (3) and a vacuum is present at the suction port of the gripper (2), and
in a second position disconnects the vacuum jet pump (1) from the compressed air supply (4) so that outlet air of the vacuum jet pump (1) stored in the receiver tank (3) flows via the vacuum jet pump (1) to the suction port of the gripper (2).

2. Gripper unit according to claim 1, **characterised in that** the controllable valve (5) and the compressed air connection of the vacuum jet pump (1) are pneumatically coupled via a flow channel (6).

3. Gripper unit according to claim 2, **characterised in that** the controllable valve (5) has an air vent via which the valve (5) and the flow channel (6) vent when the controllable valve (5) is in the second position.

4. Gripper unit according to claim 3, **characterised in that** the air vent of the valve (5) and the suction port of the gripper are pneumatically coupled.

5. Gripper unit according to claim 1, **characterised in that** the controllable valve (5) is provided directly on the vacuum jet pump (1).

6. Mounting head for a pick-and-place machine, having at least two gripper units as claimed in one of claims 1 to 5, **characterised in that** the receiver tanks (3) are implemented by at least two gripper units as a common receiver tank (8) into which the outlet air of the vacuum jet pumps (1) flows.

7. Mounting head according to claim 6, **characterised in that** a pressure regulating valve (9) is provided on the common receiver tank (8).

8. Mounting head according to one of claims 6 or 7, **characterised in that** the mounting head has a compressed air reservoir (7) which is coupled to the compressed air supply (4) and supplies the gripper units with compressed air.

9. Method for placing electrical components on substrates for a pick-and-place machine with a movable mounting head which has at least two gripper units, said gripper units each having
- a vacuum jet pump (1) which has a compressed air connection, a vacuum connection and an outlet air connection,
- a gripper (2) which has a suction port particularly for picking up electrical components, said suction port being pneumatically coupled to the vacuum connection,
- a controllable valve (5) which is provided between the compressed air connection and a compressed air supply (4), and at least one common receiver tank (8) is provided which is pneumatically coupled to at least two outlet air connections, and the controllable valve (5)
in a first position pneumatically couples the compressed air supply (4) to the compressed air connection of the vacuum jet pump (1) so that compressed air flows via the vacuum jet pump (1) into the common receiver tank (8) and a vacuum is present at the suction port of the gripper (2), and
in a second position disconnects the vacuum jet pump (1) from the compressed air supply (4) so that outlet air of the vacuum jet pump (1) stored in the common receiver tank (8) flows via the vacuum jet pump (1) to the suction port of the gripper (2), said method comprising the following steps
- switching the controllable valves (5) to the second position,
- moving the mounting head to an electrical component pick-up level,
- picking up the electrical components by means of the grippers (2) by switching the controllable valve (5) of the relevant picking-up gripper (2) to the first position and drawing the electrical component onto the suction port,
- moving the mounting head to a placement position,
- placing the electrical components on the substrate by setting the controllable valve (5) of the relevant placing gripper (2) to the second position at least long enough for the electrical component to be blown off.

10. Method according to claim 9, **characterised in that** before the electrical components are picked up, the pressure in the common receiver tank (8) is reduced by a pressure regulating valve (9) provided on the receiver tank (3).

11. Method according to claim 10, **characterised in that** before the substrate is populated the pressure in the common receiver tank (8) is increased by the pressure regulating valve (9) to a blow-off pressure that is greater than ambient pressure.

12. Method according to claim 11, **characterised in that** the pressure regulating valve (9) sets a blow-off pressure matched to the size or weight of the electrical components.

13. Method according to one of claims 9 to 12, **characterised in that** before the last electrical component is blown off by a gripper unit, the controllable valve (5) is set by at least one other gripper unit to the first position at least until the last electrical component has been blown off.

## Revendications

1. Unité de préhension, notamment pour un automate d'équipement pour l'équipement de substrats avec des composants électriques, comprenant
- une pompe à vide à jet (1) qui présente un raccord d'air comprimé, un raccord de vide et un raccord d'évacuation d'air,
- un préhenseur (2) qui présente un orifice d'aspiration, notamment pour la prise de composants électriques, l'orifice d'aspiration étant couplé pneumatiquement au raccord de vide, et
- un réservoir collecteur (3) qui est couplé pneumatiquement au raccord d'évacuation d'air,
**caractérisé en ce que**
- l'unité de préhension est munie d'une soupape commandable (5) qui est prévue entre le raccord d'air comprimé et une alimentation en air comprimé (4), la soupape commandable (5),
dans une première position, couplant pneumatiquement l'alimentation en air comprimé (4) au raccord d'air comprimé de la pompe à vide à jet (1), de sorte que de l'air comprimé circule dans le réservoir collecteur (3) par l'intermédiaire de la pompe à vide à jet (1) et que du vide est présent à l'orifice d'aspiration du préhenseur (2), et,
dans une seconde position, séparant la pompe à vide à jet (1) de l'alimentation en air comprimé (4), de sorte que l'air d'évacuation de la pompe à vide à jet (1), stocké dans le réservoir collecteur (3), circule vers l'orifice d'aspiration du préhenseur (2) par l'intermédiaire de la pompe à vide à jet (1).

2. Unité de préhension selon la revendication 1, **caractérisée en ce que** la soupape commandable (5) et le raccord d'air comprimé de la pompe à vide à jet (1) sont couplés pneumatiquement par l'intermédiaire d'un canal d'écoulement (6) .

3. Unité de préhension selon la revendication 2, **caractérisée en ce que** la soupape commandable (5) présente un orifice d'aération par l'intermédiaire duquel la soupape (5) et le canal d'écoulement (6) sont ventilés lorsque la soupape commandable (5) est réglée dans la seconde position.

4. Unité de préhension selon la revendication 3, **caractérisée en ce que** l'orifice d'aération de la soupape (5) et l'orifice d'aspiration du préhenseur sont couplés pneumatiquement.

5. Unité de préhension selon la revendication 1, **caractérisée en ce que** la soupape commandable (5) est prévue directement sur la pompe à vide à jet (1).

6. Tête d'équipement pour un automate d'équipement, comprenant au moins deux unités de préhension selon l'une quelconque des revendications 1 à 5, **caractérisée en ce que** les réservoirs collecteurs (3) sont exécutés par au moins respectivement deux unités de préhension en tant qu'un réservoir collecteur commun (8), dans lequel circule l'air d'évacuation des pompes à vide à jet (1).

7. Tête d'équipement selon la revendication 6, **caractérisée en ce qu'**une soupape de réglage de pression (9) est prévue sur le réservoir collecteur commun (8).

8. Tête d'équipement selon l'une quelconque des revendications 6 ou 7, **caractérisée en ce que** la tête d'équipement présente un réservoir d'air comprimé (7) couplé à l'alimentation en air comprimé (4), ce réservoir d'air comprimé alimentant les unités de préhension en air comprimé.

9. Procédé pour équiper des substrats avec des composants électriques pour un automate d'équipement au moyen d'une tête d'équipement déplaçable qui présente au moins deux unités de préhension, les unités de préhension présentant respectivement
- une pompe à vide à jet (1), laquelle présente un raccord d'air comprimé, un raccord de vide et un raccord d'évacuation d'air,
- un préhenseur (2) qui présente un orifice d'aspiration, notamment pour la prise de composants électriques, l'orifice d'aspiration étant couplé pneumatiquement au raccord de vide,
- une soupape commandable (5) qui est prévue entre le raccord d'air comprimé et une alimentation en air comprimé (4), et au moins un réservoir collecteur commun (8) étant prévu, qui est couplé pneumatiquement à au moins deux raccords d'évacuation d'air, et la soupape commandable (5),
dans une première position, couplant pneumatiquement l'alimentation en air comprimé (4) au raccord d'air comprimé de la pompe à vide à jet (1), de sorte que de l'air comprimé circule dans le réservoir collecteur commun (8) par l'intermédiaire de la pompe à vide à jet (1) et que du vide est présent à l'orifice d'aspiration du préhenseur (2), et,
dans une seconde position, séparant la pompe à vide à jet (1) de l'alimentation en air comprimé (4), de sorte que l'air d'évacuation de la pompe à vide à jet (1), stocké dans le réservoir collecteur commun (8), circule vers l'orifice d'aspiration du préhenseur (2) par l'intermédiaire de la pompe à vide à jet (1), le procédé comprenant les étapes suivantes
- commutation des soupapes commandables (5) en seconde position,
- déplacement de la tête d'équipement vers un plan de prélèvement des composants électriques,
- prise des composants électriques par les préhenseurs (2), du fait que la soupape commandable (5) du préhenseur (2) respectivement prenant est commutée en première position et que le composant électrique est aspiré à l'orifice d'aspiration,
- déplacement de la tête d'équipement vers un plan de montage,
- équipement du substrat avec les composants électriques, du fait que la soupape commandable (5) du préhenseur (2) respectivement équipant est réglée en seconde position au moins jusqu'à ce que le composant électrique soit évacué.

10. Procédé selon la revendication 9, **caractérisé en ce qu'**avant la prise des composants électriques, la pression dans le réservoir collecteur commun (8) est diminuée au moyen d'une soupape de réglage de pression (9) prévue sur le réservoir collecteur (3).

11. Procédé selon la revendication 10, **caractérisé en ce qu'**avant l'équipement du substrat, la pression dans le réservoir collecteur commun (8) est augmentée au moyen de la soupape de réglage de pression (9) à une pression de décharge qui est supérieure à la pression ambiante.

12. Procédé selon la revendication 11, **caractérisé en ce que** la soupape de réglage de pression (9) règle la pression de décharge adaptée à la taille ou au poids des composants électriques.

13. Procédé selon l'une quelconque des revendications 9 à 12, **caractérisé en ce qu'**avant la décharge du dernier composant électrique par une unité de préhension, la soupape commandable (5) d'au moins une autre unité de préhension est réglée sur la première position au moins jusqu'à ce que le dernier composant électrique soit déchargé.
